# EUROPEAN PATENT APPLICATION

(11) **EP 4 621 417 A1**
(43) Date of publication of application: **24.09.2025**
(21) Application number: 25164948.9
(22) Date of filing: 20.03.2025
(51) Int. Cl.: G01R 1/04, G01R 22/06, H01H 3/08, H01H 3/26

(54) **MODULE FOR MEASURING AN ELECTRICAL MAGNITUDE, ELECTRICAL TERMINAL BOARD AND RECHARGE STATION COMPRISING SAID MEASUREMENT MODULE**

(30) Priority: 21.03.2024 IT 202400006349
(71) Applicant: Silla Srl, 35127 Padova (PD) (IT)
(72) Inventor: GRILETTI, Cristiano, 35125 Padova (PD) (IT)
(74) Representative: Caldon, Giuliano

(57) **Abstract**

Measurement module (1) for detecting at least one electrical magnitude, which comprises at least one electrical conductor (2), at least one electrical sensor (3), which is operatively associated with the electrical conductor (2) for detecting at least one electrical magnitude associated with the latter and generating a corresponding electrical measurement signal, and a signal connector (96) for the communication of the measurement module (1) with external components. The measurement module (1) also comprises a galvanic interruption device (5) adapted to interrupt the passage of current through the electrical conductor (2). Also provided for is an internal display (90) for showing different information to a user, in particular relative to the energy associated with the current that crosses the electrical conductor (2). **In** addition, the electrical conductor (2) defines a concave zone (23) in which a board (40) is housed which carries the electrical sensor (3) mounted thereon.

## Description

### Field of application

The present invention regards a module for measuring an electrical magnitude, an electrical terminal board and a recharge station comprising the aforesaid measurement module, according to the preamble of the respective independent claims.

The measurement module, the electrical terminal board and the recharge station according to the invention are employable for interfacing electrical devices susceptible of absorbing and/or dispensing electrical power from an electrical energy source, in particular from a power grid. Therefore, the measurement module, the present electrical terminal board and recharge station are inserted in the field of production of measurement and safety devices for electrical plants.

### State of the art

In the field of electrical and electronic plants, the connections between electrical sources and utilities (in general electrical loads) are carried out by means of systems which, in addition to allowing the transfer of the electrical energy, carry out functions for measuring currents and voltages for energy safety and accounting purposes.

Applications of this type are present for example in electrical panels, both in civil and industrial settings, in the plants for producing electrical energy from renewable sources (e.g. photovoltaic plants, also domestic), recharge stations for electric vehicles, etc.

In particular, such systems generally operate in alternating current, or also in direct current.

The aforesaid systems of the prior art typically comprise a differential current meter, which is configured for measuring possible dispersions of current, indicative of possible failure.

In addition, in the case of applications in alternating current, the system comprises one or more phase current meters, each generally constituted by a current transducer, which is configured for detecting a quantity relative to the current present in the corresponding phase, for example a value represented of its amplitude.

Such systems of the prior art also comprise a switch, generally mechanical, which is configured for maintaining the circuit closed during the normal functioning operations, ensuring an electrical contact between two conductors, and for opening it in an automatic manner, interrupting the connection between the conductors, for example following a signal deriving from the aforesaid differential current meter or from the phase current meters.

For example, the system comprises a printed circuit board, on which the conductive tracks are obtained for defining the various electrical connections, and on which the switch is mounted together with, possibly, a further electronic board in which the control logic is implemented.

In particular, the printed circuit board is connected to multiple input cables connected to an energy source, and to multiple output cables connected to the utility or in general to the electrical load. The system also comprises multiple voltage meters, configured for measuring the voltage of each phase and sending a relative signal to the electronic board of the control logic. The latter is arranged for processing the measurements of phase current and voltage in order to measure an electric power entering or exiting from the device itself and, preferably, for processing based on the latter a measurement of electrical energy drawn from the electrical energy source or introduced towards the load.

In particular, in the systems of known type, the phase and differential current meters are placed around the output electrical cables placed downstream of the printed circuit board.

More in detail, each phase current meter has a substantially annular form and is placed around a corresponding phase cable (or, otherwise, a current deflector, known in the technical jargon with the name shunt, placed in series with the phase cable), and the differential current meter also has a substantially annular form, enclosing at its interior both the phase cables (or the phase conductor in the case of a single-phase system) and the neutral cable.

The systems of the prior art discussed briefly above have in practice demonstrated that they do not lack drawbacks.

A first drawback lies in the fact that such systems are particularly bulky, mainly due to the need to comprise the phase and differential current meters and the switch as separate devices, with the need to duplicate the connections, the relative containers, etc.

Indeed, the phase and differential current meters require a considerable amount of space to be available, which complicates the application of the system, in particular in an existing structure. A further drawback lies in the fact that the systems of the prior art are relatively costly. Indeed, their components, such as for example the differential current meter and the phase current meters, are usually available on the market in the form of integrated modules comprising an electrical sensor and a board, coming to increase the cost of the system.

### Presentation of the invention

In this situation, the problem underlying the present invention is that of overcoming the abovementioned drawbacks of the solutions of known type, by providing a module for measuring an electrical magnitude, an electrical terminal board and a recharge station comprising the aforesaid measurement module, which can be employed in a simple and reliable manner in various applications.

Further object of the present invention is that of providing a module for measuring an electrical magnitude, an electrical terminal board and a recharge station comprising the aforesaid measurement module which are structurally compact, in order to occupy a reduced space in the installation thereof.

Further object of the present invention is that of providing a module for measuring an electrical magnitude, an electrical terminal board and a recharge station comprising the aforesaid measurement module which are simple and inexpensive to attain.

### Brief description of the drawings

The technical characteristics of the invention, according to the aforesaid objects, can be clearly seen in the contents of the below-reported claims and the advantages thereof will be more evident in the following detailed description, made with reference to the enclosed drawings, which represent a merely exemplifying and non-limiting embodiment of the invention, in which:

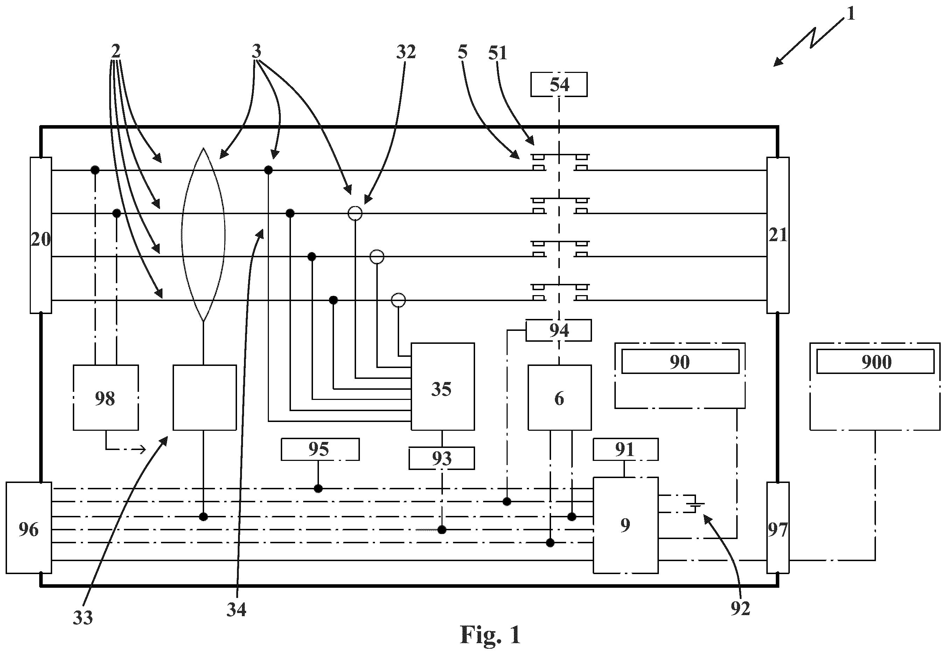

- figure 1 shows a schematic view of the module for measuring an electrical magnitude, object of the present invention;
- figure 2a shows a top front perspective view of the present measurement module;
- figure 2b shows a bottom front perspective view of the measurement module of figure 2a;
- figure 3a shows a top front perspective view of the measurement module of figure 2a with several parts removed in order to better illustrate other parts;
- figure 3b shows a bottom front perspective view of the measurement module of figure 2a with several parts removed in order to better illustrate other parts;
- figure 4 shows a rear perspective view of the measurement module of figure 2a with several parts removed in order to better illustrate other parts;
- figure 5 shows a side view of the measurement module of figure 2a with several parts removed in order to better illustrate other parts;
- figure 6 shows a detail of the measurement module of figure 2a relative to a galvanic interruption device;
- figure 7 shows an embodiment variant of the measurement module of figure 2a with several parts removed in order to better illustrate other parts;
- figure 8 shows an electrical terminal board, object of the present invention;
- figure 9 shows a recharge station, object of the present invention.

### Detailed description of a preferred embodiment

With reference to the enclosed drawings, reference number 1 overall indicates a measurement module for detecting at least one electrical magnitude according to the invention.

The present measurement module 1 comprises at least one electrical conductor 2, which is extended, along an extension direction X, between an input terminal 20 and an opposite output terminal 21. In particular, the electrical conductor 2 is at least partially made of metal material, e.g. copper or galvanized copper.

The input 20 and output 21 terminals are intended to be connected, respectively, to an upstream section 11 and to a downstream section 12 of an electric circuit in order to allow the passage of an electric current through the at least one electrical conductor 2.

In general, by electric circuit it is intended any one circuit configuration in which the present measurement module 1 is intended to be applied, and which can comprise for example part of the connections from an electrical source (such as a distribution grid) and a utility, part of an electrical panel, or part of an electric or electronic device in which the measurement module is intended to be installed.

For example, as shown in the particular embodiments discussed hereinbelow, the input 20 and output 21 terminals can be implemented respectively by means of first and second connectors PCB 24', 24", in particular connection terminals via welding, or screw or spring terminals for the connection to electrical wires (in particular for terminal boards).

The measurement module 1 also comprises at least one electrical sensor 3, which is operatively associated with the electrical conductor 2, is configured for detecting at least one electrical magnitude associated with the latter, and is provided with an output port through which it is adapted to generate an electrical measurement signal representative of the aforesaid electrical magnitude.

The measurement module 1 also comprises a support structure 4, on which the electrical sensor 3 is mounted.

In accordance with the idea underlying the present invention, the electrical conductor 2 comprises, along the extension direction X, at least one first section 221 and one second section 222, consecutive, tilted with respect to each other which delimit at least one concave zone 23.

Additionally, the support structure 4 comprises at least one board 40, which is at least partially placed in the concave zone 23, carries the electrical sensor 3 mounted thereon and is provided with conductive tracks 41 electrically connected to the output port of the electrical sensor 3 in order to transmit the electrical measurement signal.

Advantageously, the electrical sensor 3 is at least partially placed, at least with its output port, in the concave zone 23.

In this manner, the arrangement of the support structure 4 in the concave zone 23 of the electrical conductor 2 allows obtaining a particularly compact and simple configuration of the present measurement module 1, in particular allowing operatively associating the electrical sensor 3 with the electrical conductor 2 in a reduced bulk and with simple electrical connections.

This allows employing the measurement module 1 in multiple applications in a simple and inexpensive manner, without requiring costly adaptations.

In particular, the arrangement of the support structure 4 in the concave zone 23 delimited by the shaped portion 22 of the electrical conductor 2 allows optimizing the placement of the electrical conductor 2 itself, of the electrical sensor 3 and of the board 40 so as to obtain a compact configuration of the measurement module 1.

Advantageously, the electrical conductor 2 comprises a third section 223, tilted with respect to the second section 222, and such second section 222 connects the first section 221 to the third section 223.

In particular, the first, second and third section 221, 222, 223 define a shaped portion 22, substantially C-shaped, of the electrical conductor 2, and such shaped portion 22 delimits at least the concave zone 23.

In particular, the first and the third section 221, 223 are substantially parallel to each other and the second section 222 is substantially orthogonal to the latter.

More in detail, the shaped portion 22 has jagged linear shape (in other words, it has a jagged line shape), with the first section 221 and the third section 223 connected at a corner to the second section 222.

Otherwise, without departing from the protective scope of the present patent, the first and the third section 221, 223 are tilted towards each other starting respectively from the input terminal 20 and from the output terminal 21. More in detail, in this case the shaped portion 22, and more in particular the second section 222, is substantially curved, in particular arched, with a concave portion directed towards the concave zone 23.

Advantageously, the bulk of the board 40 parallel to the second section 222 of the electrical conductor 2 is completely contained in the concave zone 23. Preferably, the bulk of the board 40 parallel to the second section 222 is extended completely between the first section 221 and the third section 223 of the electrical conductor 2.

Advantageously, the board 40 does not project outside the concave zone 23 from the side of the first section 221 of the electrical conductor 2 and, preferably, it does not project outside the concave zone 23 from the side of the third section 223 of the electrical conductor 2.

Advantageously, the board 40 is provided with an external face 40' directed towards the electrical conductor 2, on which the electrical sensor 3 is placed, in particular mounted.

Advantageously, the board 40 comprises a first portion 401 which is placed alongside (and preferably substantially parallel) to the second section 222 of the electrical conductor 2.

In particular, the first portion 401 of the board 40 is extended between a first flank 401', preferably placed in proximity to the first section 221 of the shaped portion 22, and a second flank 401", opposite the first flank 401' and preferably placed in proximity to the third section 223 of the shaped portion 22.

Advantageously, the board 40 comprises a second portion 402, which is connected to the first portion 401, is tilted with respect to the first portion 401, in particular orthogonal to the latter, and is side-by-side (and preferably substantially parallel to) one between the first section 221 and the third section 223.

In particular, the second portion 402 is extended between a first margin 402' and an opposite second margin 402".

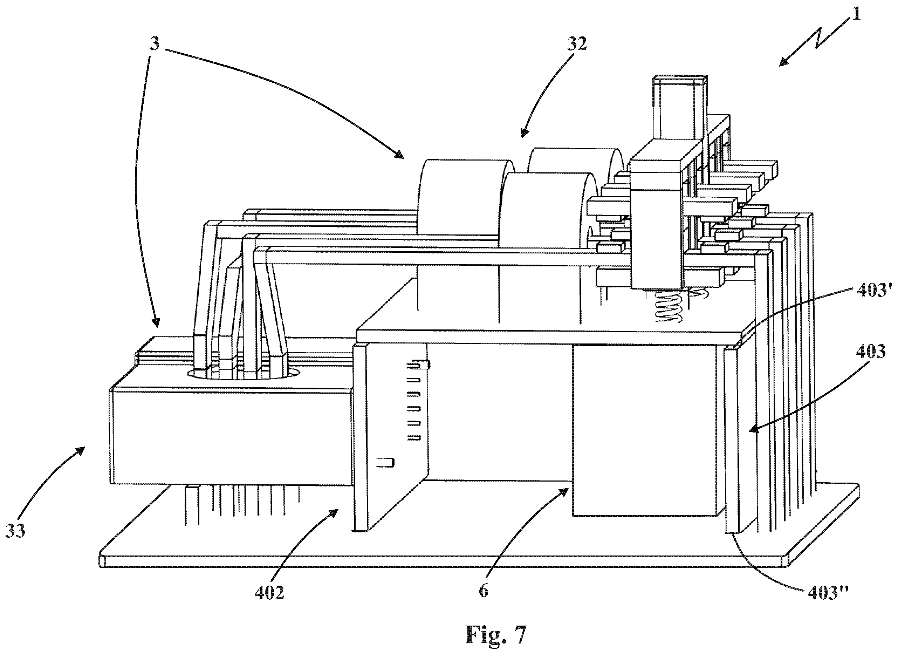

Advantageously, the board 40 is provided with an internal face 40" opposite the external face 40', and the first and the second portion 401, 402 are preferably mechanically connected (and in particular fixed to each other) respectively at the internal face 40' of the first portion 401 and of the first margin 402', for example by means of fit coupling or by means of flexible connections. Otherwise, in accordance with an embodiment variant illustrated for example in figure 7, the first and the second portion 401, 402 are mechanically connected respectively at the first flank 401' and at the first margin 402'.

Advantageously, the electrical sensor 3 is mounted on the first portion 401 or on the second portion 402 of the board 40.

In particular, in the event in which the electrical sensor 3 is mounted on the first portion 401, is coupled to the electrical conductor 2 at the second section 222 of the latter.

Otherwise, in the event in which the electrical sensor 3 is mounted on the second portion 402, it is coupled to the electrical conductor 2 at the first or third section 221, 223 of the latter (depending on the positioning of the second portion 402 side-by-side the first section 221 or the third section 223).

Advantageously, in accordance with the embodiment illustrated in figure 7, the board 40 comprises a third portion 403 which is connected to the first portion 401, is tilted with respect to the latter, preferably orthogonal thereto, and is side-by-side the other (of the first and third) section 221, 222 with respect to which it is side-by-side the second portion 402.

In accordance with the embodiment illustrated in figure 7, the second portion 402 is side-by-side the first section 221 of the electrical conductor 2 and the third portion 403 is side-by-side the third section 223 of the electrical conductor 2 itself.

In particular, the third portion 403 is extended between a first edge 403', connected to the second flank 401" of the first portion 401, and an opposite free second edge 403".

Preferably, the third portion 403 faces and is spaced from the second portion 402, forming a substantially bridge-shaped structure with the first portion 401.

In accordance with the preferred embodiment illustrated in the enclosed figures, the electrical conductor 2 comprises at least one rigid conductive bar 200, which is shaped according to the aforesaid shaped portion 22, substantially C-shaped. In particular, the aforesaid conductive bar 200 has the aforesaid jagged line form, i.e. with jagged line shape.

Otherwise, in accordance with a different embodiment, the electrical conductor 2 comprises a rigid or flexible conductor wire (optionally provided with an insulating cover), which is shaped to obtain the aforesaid substantially C-shaped shaped portion 22.

Advantageously, the measurement module 1 comprises a containment body 13, which at its interior houses the electrical conductor 2 (except at most for the input and output terminals 20, 21), the support structure 4 (and in particular the board 40) and the electrical sensor 3.

Preferably, the containment body 13 comprises a base wall 14, substantially plate-like, and a closure cover 15 applied in a removable manner to the base wall 14 in a manner such to enclose the electrical conductor 2, the support structure 4 and the electrical sensor 3 between the closure cover 15 and the base wall 14 themselves.

Optionally, the input 20 and output 21 terminals of the electric cable 2 are placed at the base wall 14 or at the containment body 13 (in particular on the base wall 14 of the latter).

Advantageously, the second margin 402' of the second portion 402 and, preferably, the second edge 403" of the third portion 403 are placed in abutment against the base wall 14 of the containment body 13.

Advantageously, as discussed in detail hereinbelow, the measurement module 1 comprises a signal connector 96 (for example, physically attained with a third connector PCB 24‴) which is arranged in order be connected to electronic components for transmitting electrical signals (in particular with low voltage) from and towards the measurement module 1 itself.

Advantageously, the measurement module 1 comprises a galvanic interruption device 5, which is preferably mounted on the external face 40' of the board 40, and is in particular placed to intercept the electrical conductor 2.

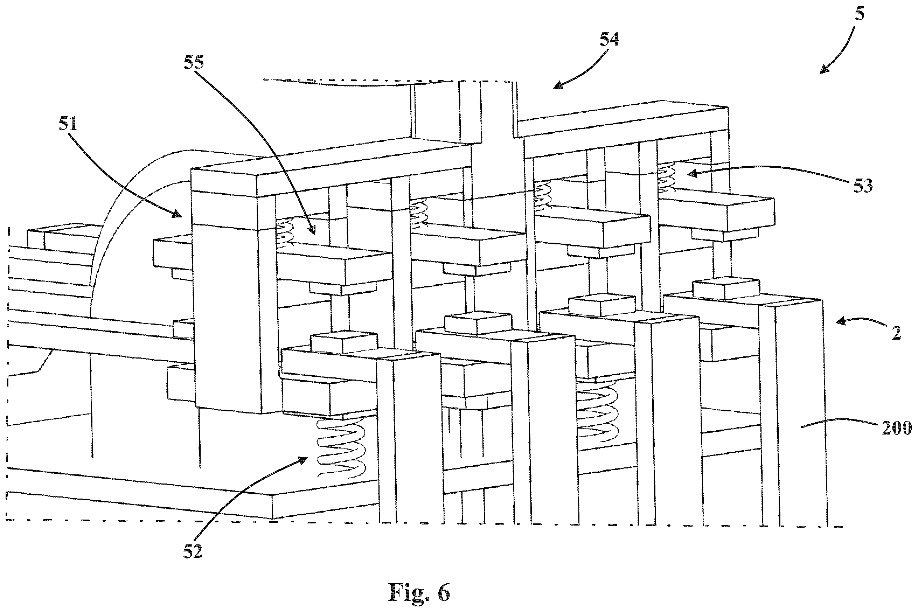

Advantageously, such galvanic interruption device 5 is actuatable, for example as a function of the electrical measurement signal provided by the electrical sensor 3 or of an external signal transmitted through the aforesaid signal connector 96, to switch between an open position (illustrated for example in figure 6), in which it electrically isolates the input terminal 20 from the output terminal 21 of the electrical conductor 2, and a closed position, in which it electrically connects the input terminal 20 to the output terminal 21.

Preferably, as a function of the electrical measurement signal, the galvanic interruption device 5 is actuatable to switch from the closed position to the open position and/or vice versa.

Preferably, in accordance with the preferred embodiment illustrated in the enclosed figures, the galvanic interruption device 5 is operatively connected to the electrical sensor 3 and is actuatable to switch between the open and closed positions as a function of the electrical measurement signal generated by the electrical sensor 3 itself.

Otherwise, in accordance with a different embodiment, the galvanic interruption device 5 is operatively connected to the signal connector 96 in order to receive, from the latter, a signal as a function of which it is actuatable to switch between the open and closed positions.

Preferably, the electrical conductor 2 comprises a first part extended from the input terminal 20 to a first contact connected to the galvanic interruption device 5, and a second part extended from a second contact to the galvanic interruption device 5 at the outlet terminal 21.

Advantageously, the galvanic interruption device 5 comprises a non-illustrated fixed portion, which is preferably fixed with respect to the support structure 4, for example constrained to the support structure 4 itself or to a different support structure, not illustrated, integral with the support structure 4, and a movable portion 51 mechanically connected to the fixed portion, provided with at least one contact body 55 (made of conductive material) and movable (with respect to the fixed portion) between the open position, in which the contact body 55 is separated from at least one of the contacts of the two sides of the electrical conductor 2, and the closed position, in which the contact body 55 has electrical contact with both contacts of the two sides of the electrical conductor 2 in order to allow the passage of electric current.

Preferably, the galvanic interruption device 5 (in particular with its fixed portion 50) is mounted on the first portion 401 of the board 40, intercepting the second section 222 of the electrical conductor 2.

Advantageously, the first portion and the second portion 401, 402 (preferably with the third portion 403) of the board 40 delimit, on the internal face 40", an internal seat 42.

Preferably, such internal seat 42 is on the bottom delimited by the base wall 14 of the measurement module 1.

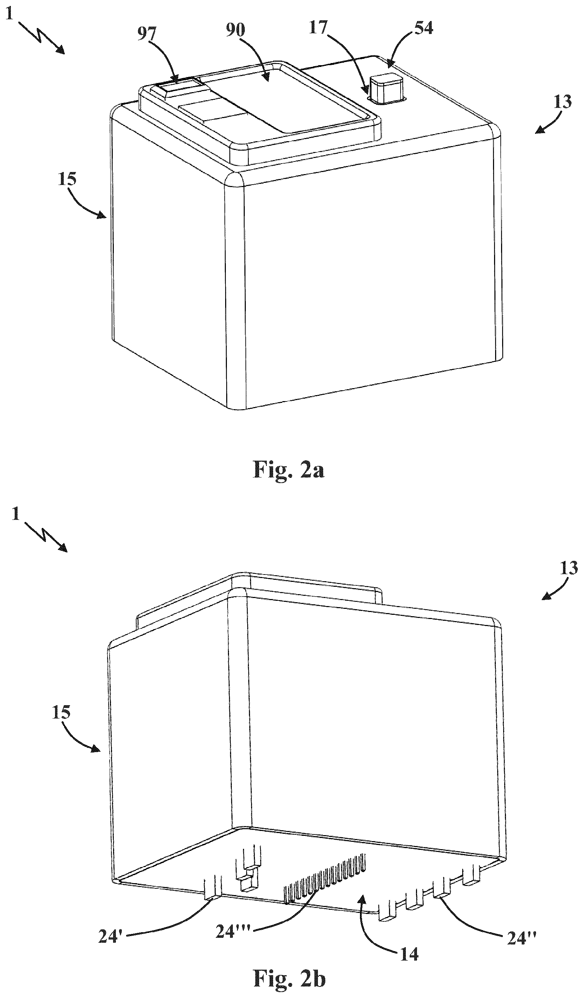

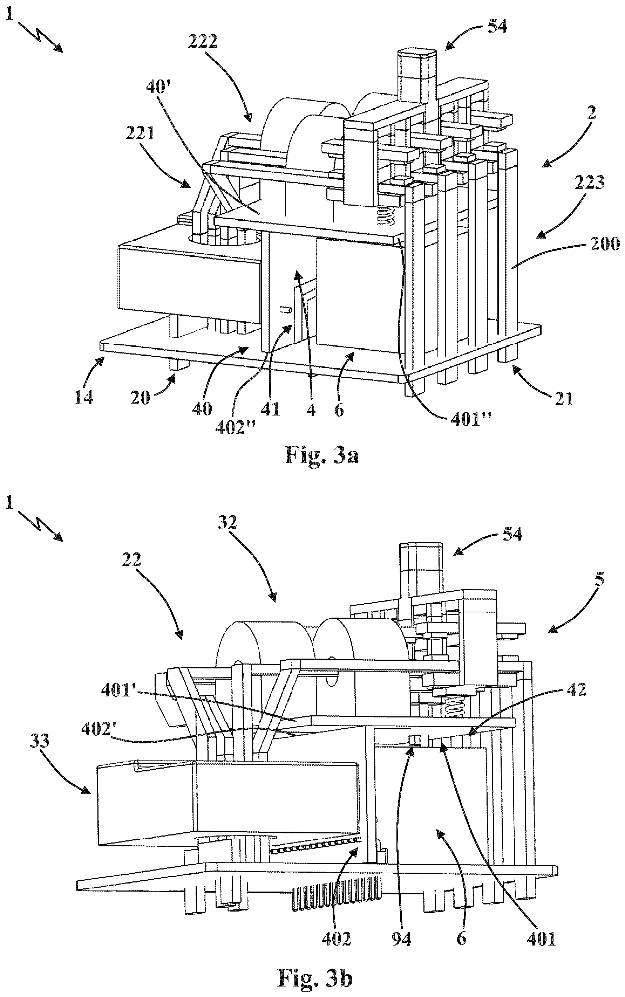

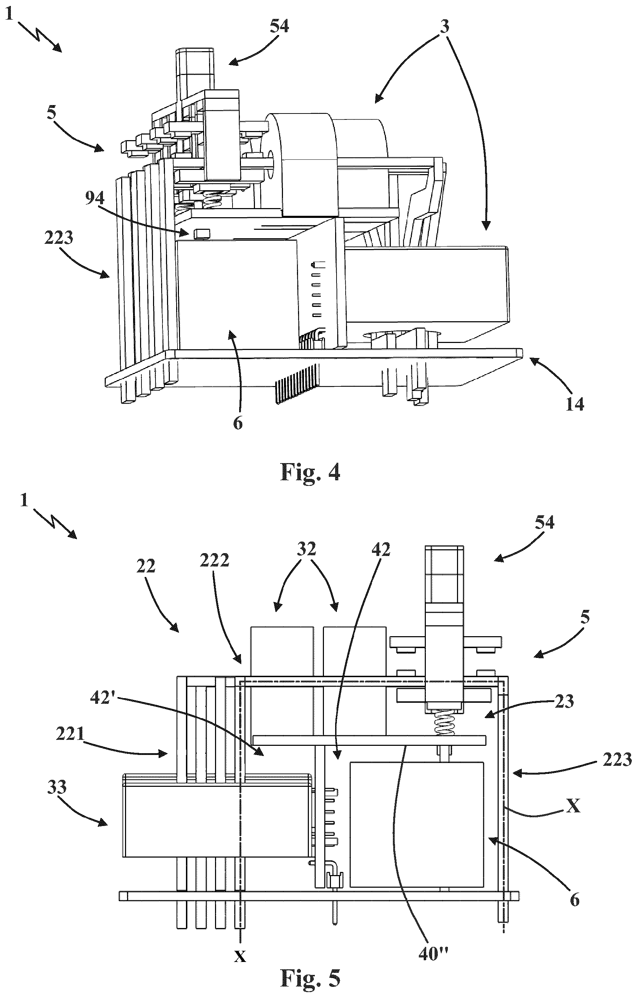

Advantageously, the measurement module 1 comprises an actuator 6 (illustrated for example in a schematic manner in figures 2-5 and 7), with electrical actuation, placed in the aforesaid internal seat 42, operatively connected to the electrical sensor 3 (or, otherwise, to the signal connector 96) and mechanically connected to the galvanic interruption device 5 in order to actuate the latter (and in particular its movable portion 51) to switch into at least one of the aforesaid open and closed positions.

In accordance with a particular embodiment, the galvanic interruption device 5 comprises elastic means 52 (for example one or more springs) connected to the movable portion 51 and configured for forcing them into the open position. Advantageously, the actuator 6 is configured for acting on the movable portion 51 in order to overcome the force of the elastic means 52, so as to bring the movable portion 51 into closed position, and in order to release the movable portion 51, so as to allow the movable portion 51 to be carried into the open position by the force exerted by the elastic means 52.

Preferably, the galvanic interruption device 5 comprises one or more contact bodies 55, each of which configured for receiving in abutment at least part of the electrical conductor 2 in order to allow the passage of electric current between the input terminal 20 and the output terminal 21. In particular, the galvanic interruption device 5 is provided with one or more stabilization springs 53, each of which mechanically connected to a corresponding contact body 55 in order to make uniform the distribution of the force of the latter on the corresponding electrical conductors 2.

Advantageously, the actuator 6 comprises, in a per se known manner, an electric motor mechanically connected to the movable portion 51 of the galvanic interruption device 5 and actuatable for moving such movable portion 51 between the closed position and the open position. Otherwise, the actuator 6 comprises, in a per se known manner, an electromagnet provided with an excitation coil and with an actuation element connected to the movable portion 51 of the galvanic interruption device 5 in order to actuate the latter to switch into the open or closed position.

Advantageously, the measurement module 1 comprises at least one manual actuation device 54, which is mechanically connected to the galvanic interruption device 5, and is actuatable by a user in order to switch the galvanic interruption device 5 itself at least into the closed position.

In particular, the manual actuation device 54 comprises an actuation element, such as for example a button, accessible by a user and actuatable by the latter, preferably by exerting a pressure thereon, in order to bring the galvanic interruption device 5 into the closed position, for example after the latter has been switched into open position by the actuator 6.

More in detail, the closure cover 15 of the containment body 13 is preferably provided with a passage opening 17 crossed by the aforesaid actuation element of the manual actuation device 54 in order to allow the user to act easily on the latter.

In accordance with the example of the enclosed figures, the manual actuation device 54 is fixed to the movable portion 51 of the galvanic interruption device 5.

Optionally, in accordance with an embodiment not illustrated in the enclosed figures, the manual actuation device 54 is connected to the galvanic interruption device 5 by means of a latching device, per se known, configured for automatically bringing the galvanic interruption device 5 (and in particular the movable portion 51) into the open position if, following the actuation of the manual actuation device 54, the error detected (in particular by the electrical sensor 3, or transmitted from the outside through the signal connector 96), relative for example to an overcurrent and/or an overvoltage and/or a differential current beyond a certain threshold value, continues to remain.

In an embodiment variant of the measurement module 1, the manual actuation device 54 is configured for bringing the galvanic interruption device 5 both from the open position to the closed position and vice versa, or otherwise only from the closed position to the open position.

Advantageously, the actuator 6 is configured for bringing the galvanic interruption device 5 back into the closed position (following an opening thereof) without the intervention of an external user, for example based on the electrical measurement signal.

In accordance with the embodiments illustrated in the enclosed figures, the present measurement module 1 comprises multiple electrical sensors 3, regarding which several preferred implementations are described hereinbelow.

Advantageously, the electrical sensors 3 (or more generally the at least one electrical sensor 3) comprise at least one current sensor 32 applied to the electrical conductor 2.

In particular, the current sensor 32 is configured for detecting, in a per se known manner, an electric current value, for example relative to a current intensity passing into the electrical conductor 2, and for generating the corresponding electrical measurement signal. More in detail, in accordance with the example illustrated in the enclosed figures, the current sensor 32 is a current transducer, which is placed to at least partially enclose of the electrical conductor 2. Otherwise, in accordance with a non-illustrated embodiment, the current sensor is obtained with a current diverter, known in the technical jargon with the name shunt, placed in series with the electrical conductor 2.

In accordance with the preferred embodiment illustrated in the enclosed figures, the current sensor 32 is placed at the second section 222 of the shaped portion 22 of the electrical conductor 2 and, in particular, is mounted on the first portion 401 of the board 40.

Advantageously, the current sensor 32 is operatively connected to the galvanic interruption device 5, and preferably to the actuator 6. In this manner, in particular, the galvanic interruption device 5 is arranged for being actuated by the actuator 6 to switch between the closed position and the open position based on the electrical measurement signal relative to the current value.

Advantageously, the electrical sensors 3 (or more generally the at least one electrical sensor 3) comprise at least one voltage sensor 34, which is operatively associated with the electrical conductor 2 and is configured for detecting a magnitude value of the latter relative to an electric voltage thereof and for generating a corresponding electrical measurement signal.

Advantageously, the measurement module 1 comprises an energy measurement unit 35, operatively connected to the current sensor 32 and to the voltage sensor 34.

In particular, the energy measurement unit 35 comprises a calculation module, which is configured for receiving the electrical measurement signals from the current sensor 32 and from the voltage sensor 34 and for calculating, based on the latter, at least one value representative of the electrical energy associated with the electric current.

In other words, the voltage sensor 34 and the current sensor 32 are integrated into the energy measurement unit 35, which is in particular arranged for providing parameters relative to the electrical energy associated with the current intensity and with the voltage detected by the aforesaid sensors 32, 34.

Advantageously, the measurement module 1 comprises a logic control unit 9 (comprising in particular at least one microprocessor), which is operatively connected at least to the electrical sensor 3 (or to the electrical sensors 3) on order to receive the electrical measurement signal from the latter.

Preferably the logic control unit 9 is operatively connected to the actuator 6 and is arranged for commanding the latter to switch the galvanic interruption device 5 between the open position and the closed position, for example based on the aforesaid electrical measurement signals (or, otherwise, based on external signals transmitted through the signal connector 96).

In particular, the logic control unit 9 is operatively connected to the current sensor 32, and is configured for determining an overcurrent value based on the electrical measurement signal deriving from the current sensor 32 itself, for example comparing it with a threshold value, and consequently commanding the actuation of the galvanic interruption device 5 into the open position.

Preferably, the logic control unit 9 is operatively connected to the voltage sensor 34, and is configured for determining, based on the electrical measurement signals of the voltage sensor 34 and of the current sensor 32, one or more values representative of the electrical energy (and/or of the electric power) transmitted between the input terminal 20 and the output terminal 21 of the electrical conductor 2.

Otherwise, without departing from the protective, object of the present invention, the energy measurement unit 35 can be used for directly determining the aforesaid values representative of the electrical energy and/or of the electric power, in particular if it was not convenient to carry out such calculations and signal conversions within the logic control unit 9.

Advantageously, the logic control unit 9 is configured for electronically signing the determined electrical energy value, comprising for example, for such purpose, a Trusted Platform Module 91, which is configured for storing one or more encryption keys used for electronically signing the values representative of the electrical energy.

The logic control unit 9 is advantageously provided with a real time clock module (RTC), known to the man skilled in the art and therefore not described in depth hereinbelow. Advantageously, the measurement module 1 comprises an internal display 90 (preferably mounted on the containment body 13, and more preferably at the closure cover 15) operatively connected to the logic control unit 9, in order to show data associated with the electrical magnitude and, advantageously, other states of the measurement module 1.

Optionally, the measurement module 1 comprises an external display 900, placed outside the containment body 13 and operatively connected to the logic control unit 9, for example directly or, otherwise, through a connector. In particular, the logic control unit 9 is arranged for sending data signals to the external display 900. More in detail, such data signals can be visible or if necessary encrypted.

In particular, the measurement module 1 comprises communication lines, which are electrically connected to the logic control unit 9 and to the external display 900 and are adapted to transmit the information between the latter, optionally tamper-proof, for example in encrypted form. More in detail, the external display 900 can comprise a TPM module and/or a further logic control unit adapted to decode the received encrypted data. Optionally, the external display 900 is connected to the signal connector 96 in order to receive, from the latter, information coming from the outside. Advantageously, the external display 900 and/or the internal display 90 comprise one or more interface devices (such as buttons, touch screens, LEDs, etc.) and possibly other identifying and functional elements that are per se known in the field of reference, such as for example the printing of operative information and pictograms such as for example a QR code containing a public encryption key.

Advantageously, the logic control unit 9 is placed (at least partially) in the internal seat 42 of the board 40.

Preferably, the logic control unit 9 is mounted on the board 40, more preferably on the internal face 40" of the latter, optionally on the first portion 401 or on the second portion 402. In accordance with a different embodiment, the logic control unit 9 is mounted on the base wall 14 of the measurement module 1.

Advantageously, the present measurement module 1 can be employed both for application in alternating current and in direct current, as is better specified hereinbelow.

Preferably, the measurement module 1 comprises at least two electrical conductors 2.

In accordance with the preferred embodiment illustrated in the enclosed figures, relative to an application in alternating three-phase current, the measurement module 1 comprises four electrical conductors 2. In particular, in this case, three of the four electrical conductors 2 are electrical phase conductors and one of the four electrical conductors 2 is a neutral conductor.

Advantageously, multiple distinct current sensors 32 (e.g., three) are provided for, each of which associated with the corresponding electrical conductor 2, in particular with a corresponding phase conductor.

Advantageously, the measurement module 1 comprises in this case multiple voltage sensors 34, configured for detecting a voltage measurement between a corresponding phase conductor and the neutral conductor, or between two distinct phase conductors.

In accordance with a different non-illustrated embodiment, intended for a three-phase application without neutral conductor, the measurement module 1 comprises three electrical conductors 2. In accordance with a non-illustrated further embodiment, the measurement module 1 comprises two electrical conductors 2, in the event in which it is intended to be electrically connected to a single-phase external load or grid in alternating current.

For example, in case of application in alternating single-phase current, one of the two electrical conductors 2 is a phase conductor, and the other of the two electrical conductors 2 is a neutral conductor; or, otherwise, are both phase conductors. More in detail, in this case the current sensor 32 is associated with only one of the two electrical conductors 2, preferably with a phase conductor.

In accordance with a non-illustrated further embodiment, the measurement module 1 comprises two electrical conductors 2, in the event in which it is intended to be electrically connected to a direct current system. In such case the current sensors 32 are preferably of the type suitable for direct current measurement (for example shunt).

Preferably, the measurement module 1 comprises one or more spacer elements, made of electrically insulating material, for example of polymer material, each of which at least partially interposed between two side-by-side electrical conductors 2 in order to maintain them spaced.

Advantageously, the electrical sensors 3 comprise a current differential sensor 33 operatively associated with the electrical conductors 2.

In particular, in the event in which the measurement module 1 comprises four electrical conductors 2, the current differential sensor 33 is associated with all four electrical conductors 2. In accordance with the preferred embodiment illustrated in the enclosed figures, the current differential sensor 33 is placed at the first section 221 of the shaped portion 22 of the electrical conductors 2 and is mounted on the second portion 402 of the board 40.

More in detail, in accordance with the illustrated preferred embodiment, the first and the second portion 401, 402 define a further internal seat 42', side-by-side the aforesaid internal seat 42, within which the current differential sensor 33 is advantageously housed.

In particular, such current differential sensor 33 has substantially annular form, provided with a central hole in which the electrical conductors 2 are placed. More in detail, in a per se known manner, the current differential sensor 33 is arranged for detecting the difference between the entering and exiting electrical currents that cross the electrical conductors 2. In operation, when the current differential sensor 33 detects that the aforesaid difference exceeds a predetermined threshold value, it is configured in order to transmit a corresponding electrical measurement signal through the board 40 on which it is mounted, for example to the galvanic interruption device 5 and/or to the logic control unit 9 and/or to the signal connector 96.

Advantageously, the current differential sensor 33 comprises a toroidal placed around the electrical conductors 2. Preferably, the current differential sensor 33 comprises a processing module, advantageously comprising per se known electronic components, and such processing module is electrically connected to the aforesaid toroidal.

In particular, the current differential sensor 33 is configured for measuring differential currents both in direct current and in alternating current. For example, the current differential sensor 33 can comprise a fluxgate magnetometer, per se known to the man skilled in the art.

More in detail, the current differential sensor 33 is operatively connected to the logic control unit 9 in order to transmit, to the latter, the corresponding electrical measurement signal. In particular, the logic control unit 9 can be configured for commanding, following the electrical measurement signal relative to the measurement of differential current, the actuator 6 such that the latter actuates the galvanic interruption device 5 between the open position and the closed position and, in particular, from the closed position to the open position.

Advantageously, the logic control unit 9 is arranged for testing, in a periodic manner, the current differential sensor 33, in particular for verifying its operation.

Advantageously, the board 40 comprises at least one circuit board, whose tracks in particular define the conductive tracks 41 of the board 40 for transmitting the measurement signals generated by the electrical sensors 3.

Preferably, the board 40 comprises two printed circuits, of which one defines the first portion 401 and the other the second portion 402.

More in detail, the conductive tracks 41 of the first and of the second portion 401, 402 are electrically connected to each other, in accordance with the electrical connections necessary for transmitting the measurement signals, as discussed hereinbelow.

For such purpose, in particular, the first and the second portion 401, 402 are electrically connected by means of electrical connectors, welds, or flexible printed circuits, in a per se known manner. Optionally, the base wall 14 of the measurement module comprises a corresponding circuit board, which is provided with further conductive tracks electrically connected to the conductive tracks of the board 40.

Preferably, the third portion 403 is made of electrically insulating material, for example of polymer material, and in particular does not comprise the aforesaid conductive tracks 41, only having the function for example of structural support.

Advantageously, the signal connector 96 is operatively connected to at least one from among: the electrical sensors 3 and/or the logic control unit 9 and/or the actuator 6 and/or the manual actuation device 54 and/or the energy measurement unit 35 and/or the internal display 90 and/or the external display 900 and/or a position sensor 94 (discussed hereinbelow).

For example, such connector can comprise pin header (for the connection to printed circuits) or screw or spring terminal (for the connection to electrical cables).

Advantageously, the input 20 and output 21 terminals of the electrical conductor 2 and/or of the signal connector 96 comprise at least one PCB connector and/or a terminal to be welded, which is preferably arranged for being electrically connected to an external printed circuit board.

In particular, the input terminal 20 comprises a first connector PCB 24' and, preferably, the output terminal 21 comprises a second connector PCB 24", for connecting the electrical conductor 2 to the external printed circuit board.

Advantageously, the signal connector 96 comprises a third connector PCB 24‴ for electrically connecting at least one of the internal components of the measurement module 1 (such as for example the electrical sensor 3 and/or the logic control unit 9 and/or the actuator 6) to the module of the external printed circuit board.

Advantageously, the terminals 24', 24" and 24‴ are arranged for being associated with a PCB by means of welding.

Optionally, the signal connector 96 (and in particular its third connector PCB 24‴) is fixed to the support structure 4 of the measurement device 1 (preferably to the board 40, for example to the second portion 402 of the latter), or to the base wall 14.

Advantageously, such signal connector 96 is arranged for providing an input power supply to at least one of the components of the measurement module 1, for example to the current differential sensor 33, to the energy measurement unit 35 and, preferably, to the logic control unit 9 and to the actuator 6 and, still more preferably, to the internal display 90 and/or to the external display 900, and/or to the Trusted Platform Module 91.

Advantageously, the aforesaid signal connector 96 is arranged in order to transmit data signals from and/or towards: the current differential sensor 33 (for example in order to emit alarm signals towards the external electronic components that were generated by the latter), and/or the current sensors 32 and voltage sensors 34 (in particular integrated in the energy measurement unit 35), and/or the actuator 6, and/or the logic control unit 9 and/or towards the external display 900.

Advantageously, the measurement module 1 comprises an internal power supply device 98, which is electrically connected, at the input, to the electrical conductors 2 and, at the output, to one or more of the components of the measurement module 1, such as in particular, to the current differential sensor 33, to the energy measurement unit 35 and, preferably, to the logic control unit 9 and to the actuator 6 and, still more preferably, to the internal display 90 and/or to the external display 900, and/or to the display at the Trusted Platform Module 91.

Such power supply device 98 is arranged for receiving, at the input, the current that flows into the electrical conductors 2 and for providing, at the output, a power supply signal having voltage and current intensity compatible with those of the aforesaid components of the measurement module 1.

Optionally, the power supply device 98 can be employed for power supplying the aforesaid components in alternating current with the input power supply provided by means of the signal connector 96 and optionally bring back such power supply to the signal connector 96.

Advantageously, the measurement module 1 comprises an auxiliary connector 97, which operatively and electrically connects the logic control unit to the external display 900.

Preferably, the logic control unit 9 comprises a continuity battery 92, which is arranged for coming into operation following tampering attempts of the measurement module 1. Advantageously, the continuity battery 92 is arranged for allowing a continuous power supply of the modulo RTC, so as to allow, for example the logic control unit 9, to store the electrical energy values determined by the energy measurement device 35 or by the logic control unit 9.

Advantageously, the measurement module 1 comprises at least one galvanic insulation device 93, which is electrically interposed between the energy measurement unit 35 and the logic control unit 9, in order to prevent electrical discharges towards the latter.

Advantageously, the measurement module 1 comprises a position sensor 94, operatively connected to the galvanic interruption device 5 and arranged for emitting an electrical position signal when the galvanic interruption device 5 itself is switched into the open position and/or into the closed position.

**In** particular, such position sensor 94 operatively connected to the movable portion 51 of the galvanic interruption device 5 and arranged for emitting an electrical position signal representative of at least one state of the galvanic interruption device 5 selected from among: the closed position, the open position and at least one intermediate position between the aforesaid closed position and open position.

In particular, the electrical position signal is representative of the current position of the galvanic interruption device 5.

More in detail, the intermediate position of the galvanic interruption device 5 corresponds to a position in which the contact body 55 is not completely separated from at least one of the contacts of the two sides of the electrical conductor 2 (and therefore is not situated in the open position), nor is it in electrical contact with both contacts of the two sides of the electrical conductor 2 in order to allow the passage of electric current 2 (and therefore is not situated in the closed position). Preferably, the position sensor 94 is configured in order to transmit the aforesaid electrical position signal to the logic control unit 9 and/or to the signal connector 96. For example, such position sensor 94 comprises a magnetic, optical or contact sensor mounted preferably on the board 40, and a stress lever integral with the movable portion 51 and adapted to come into contact with the position sensor when the movable portion 51 is in the open position in order to command such position sensor 94 to emit a confirmation signal that is transmitted to the logic control unit 9 and/or to the signal connector 96. In this manner, the latter, when it has commanded the actuator 6 to bring the galvanic interruption device 5 into the open position, is capable of actually detecting that the movable portion 51 has been correctly moved. An absence of such signal in fact signifies that the galvanic interruption device 5 has remained in the closed position (for example via melting of the contacts), hence not ensuring the necessary safety conditions.

Advantageously, the position sensor 94 (or, otherwise, a non-illustrated second detection sensor) is configured for detecting when the galvanic interruption device 5 is in closed position.

Advantageously, the measurement module 1 also comprises a temperature sensor 95 (preferably mounted on the board 40), which is arranged for detecting a temperature of the measurement module 1 itself, or at least of a part thereof, for example of the electrical conductors 2 and, in particular, sending a corresponding electrical temperature signal to the logic control unit 9 and/or to the signal connector 96, for example for diagnostic aims.

In accordance with a non-claimed embodiment of the measurement module 1, the at least one electrical conductor 2 lacks consecutive tilted sections (in particular of the first, second and third section 221, 222, 223), and/or the board 40 is not placed in a concave zone delimited by the electrical conductor 2.

Also forming the object of the present invention is an electrical terminal board 7.

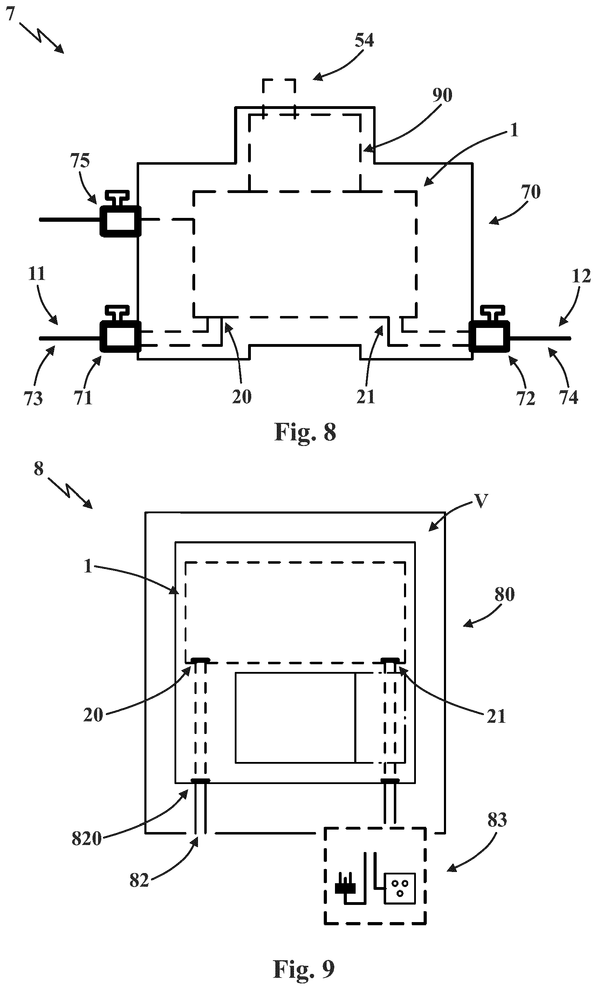

With reference to figure 8, the electrical terminal board 7 comprises at least one first terminal 71, intended to be connected to at least one first electrical cable 73, and at least one second terminal 72, intended to be connected to at least one second electrical cable 74.

The electrical terminal board 7 also comprises the abovementioned measurement module 1, regarding which the same reference numbers are maintained for the sake of description simplicity. The input terminal 20 of the electrical conductor 2 of the measurement module 1 is electrically connected to the first terminal 71, and the output terminal 21 of the electrical conductor 2 is electrically connected to the second terminal 72.

For example, the first and the second terminal 71, 72 are of screw or spring type (of per se conventional type).

Advantageously, the electrical terminal board 7 comprises one or more signal terminals 75 operatively connected to the signal connector 96 and preferably intended to bring back the signals transmitted by means of the latter.

Advantageously, the electrical terminal board 7 comprises a support body 70, on which the terminals 71, 72 and the signal terminals 75 are mechanically mounted and which preferably contains the measurement module 1 thereof at its interior.

Preferably, the support body 70 comprises a coupling portion arranged for being coupled to a DIN guide.

For example, the present electrical terminal board 7 is employable in a junction box or in an electrical panel installed for example in a home or in a private or commercial establishment or in an industrial electrical panel.

Advantageously, the electrical terminal board 7 allows an easy installation due to the reduced volume of the measurement module 1 and to the integration of multiple functions, per se known to the man skilled in the art.

Preferably, the electrical terminal board 7 also ensures the electrical safety of the electric circuit to which it is intended to be connected and, more preferably, the accounting of the energy dispensed or absorbed by the electric circuit itself.

Advantageously, the measurement module 1 of the electrical terminal board 7 can comprise only some of the above-described components, such as for example the current sensor 32 and/or the current differential sensor 33, and/or the energy measurement unit 35, and/or the galvanic interruption device 5 /or the actuator 6 and/or the logic control unit 9 and/or the signal connector 96 and/or the internal display 90 and/or the external display 900, etc.

Also forming the object of the present invention is a recharge station 8 for an electric vehicle. With reference to figure 9, the recharge station 8 comprises a containment body 80, which internally delimits a containment volume V.

The recharge station 8 also comprises at least one input line 82 (comprising for example an electrical input cable or an input connector), which is at least partially placed inside the containment volume V of the containment body 82 and is intended to be connected to an energy source outside the containment volume V.

The input terminal 20 of the electrical conductor 2 is operatively connected to the input line 82 and the output terminal 21 can be operatively connected to further components of the recharge station 8.

In particular, in the event in which the input line 82 comprises an electrical input cable, the latter is provided with a first end intended to be connected to an energy source (for example a distribution power grid) and with an opposite second end 820 placed inside the containment volume V.

The recharge station 8 also comprises the abovementioned measurement module 1, which is placed in the containment volume V of the containment body 80 of the recharge station 8 itself. The recharge station 8 also comprises an electrical connector 83, which can comprise an electrical outlet and/or an electrical plug, depending on the specific request.

Such electrical connector 83 can be operatively connected to the output terminal 21 of the electrical conductor 2 of the measurement module 1, for example directly or by means of other electronic components (e.g., relay) electrically installed in series with the output terminal 21. Advantageously, the electrical connector 83 is provided with multiple poles (as a function of the configuration of the input line 82, described above), and such poles electrically correspond to the output terminals 21 of the corresponding electrical conductors 2 of the measurement module 1. In particular, the electrical connector 83 is configured can be connected to the recharge plug of an electric vehicle.

Otherwise, in the event in which the electrical connector 83 is an electrical outlet, this is advantageously mounted on the containment body 80 and intended to receive, inserted therein, a recharge plug of a recharge cable conventionally provided with an electric vehicle.

Advantageously, the signal connector 96 of the measurement module 1 is arranged for electrically connecting the measurement module 1 with auxiliary components of the recharge station 8.

In particular, the measurement module 1 can be mounted on a circuit board comprising the aforesaid auxiliary components necessary for a correct operation of the recharge station 8, such as for example a system of communication with the electric vehicle, an electrical power supply, one or more data processing systems (comprising for example a microprocessor) and user interface systems, etc., per se known.

Alternatively, the measurement module 1 can be installed in the recharge station 8 in an electrical terminal board 7 (described above), for example in the event in which the electrical terminal board 7 is preferably in the context of attaining the recharge station 8 itself.

The invention thus conceived therefore attains the pre-established objects.

## Claims

1. Measurement module (1) for detecting at least one electrical magnitude, which comprises:
- at least one electrical conductor (2), which is extended, along an extension direction (X), between an input terminal (20) and an opposite output terminal (21), which are intended to be connected, respectively, to an upstream section (11) and to a downstream section (12) of an electric circuit in order to allow the passage of an electric current through said at least one electrical conductor (2);
- at least one electrical sensor (3), which is operatively associated with said at least one electrical conductor (2), is configured for detecting at least one electrical magnitude associated with said at least one electrical conductor (2), and is provided with an output port through which it is adapted to generate an electrical measurement signal representative of said electrical magnitude;
- a support structure (4), on which said at least one electrical sensor (3) is mounted;
said measurement module (1) being **characterized in that:**
- said at least one electrical conductor (2) comprises, along said extension direction (X), at least one first section (221) and one second section (222), consecutive, tilted with respect to each other, which delimit at least one concave zone (23);
- said support structure (4) comprises at least one board (40), which is at least partially placed in said concave zone (23), carries said at least one electrical sensor (3) mounted thereon, and is provided with conductive tracks (41) electrically connected to the output port of said electrical sensor (3) in order to transmit said electrical measurement signal.

2. Measurement module (1) according to claim 1, **characterized in that** said electrical conductor (2) comprises a third section (223), tilted with respect to said second section (222), such second section (222) connecting said first section (221) to said third section (223); said first, second and third sections (221, 222, 223) defining a shaped portion (22), substantially C-shaped, of said at least one electrical conductor (2), such shaped portion (22) delimiting at least said concave zone (23).

3. Measurement module (1) according to claim 2, **characterized in that** said board (40) comprises:
- a first portion (401) which is placed alongside the second section (222) of said electrical conductor (2);
- a second portion (402), which is connected to said first portion (401), is tilted with respect to said first portion (401) and is placed alongside one between said first section (221) and said third section (223);
wherein said at least one electrical sensor (3) is mounted on at least one between said first portion (401) and said second portion (402).

4. Measurement module (1) according to any one of the preceding claims, **characterized in that** said board (40) is provided with an external face (40') directed towards said at least one electrical conductor (2), and on such external face (40'), said at least one electrical sensor (3) is placed.

5. Measurement module (1) according to any one of the preceding claims, **characterized in that** it comprises a galvanic interruption device (5) placed to intercept said at least one electrical conductor (2), and actuatable to switch between an open position, in which it electrically isolates said input terminal (20) from said output terminal (21), and a closed position, in which it electrically connects said input terminal (20) to said output terminal (21).

6. Measurement module according to claims 3, 4 and 5, **characterized in that**:
- said galvanic interruption device (5) is placed on the external face (40') of said board (40);
- said board (40) is provided with an internal face (40") opposite said external face (40');
- the first portion and the second portion (401, 402) of said board (40) delimit, on said internal face (40"), an internal seat (42);
- said measurement module (1) comprises an actuator (6), with electrical actuation, placed in said internal seat (42), operatively connected to said at least one electrical sensor (3) and mechanically connected to said galvanic interruption device (5) in order to actuate said galvanic interruption device (5) to switch into at least one of said open and closed positions.

7. Measurement module (1) according to claim 5 or 6, **characterized in that** it comprises at least one manual actuation device (54), which is mechanically connected to said galvanic interruption device (5) and is actuatable by a user in order to switch said galvanic interruption device (5) at least into said closed position.

8. Measurement module (1) according to any one of the claims from 5 to 7, **characterized in that** it comprises at least one position sensor (94) operatively connected to said galvanic interruption device (5) and arranged for emitting an electrical position signal representative of at least one state of said galvanic interruption device (5) selected from among: said closed position, said open position, at least one intermediate position between said closed position and said open position.

9. Measurement module (1) according to any one of the preceding claims, **characterized in that** said at least one electrical sensor (3) comprises at least one current sensor (32) applied to said at least one electrical conductor (2);
wherein said electrical sensor (3) comprises at least one voltage sensor (34), which is operatively associated with said electrical conductor (2) and is configured for detecting a magnitude value of the latter relative to an electric voltage and to generate a corresponding electrical measurement signal;
wherein said measurement module (1) comprises an energy measurement unit (35), operatively connected to said current sensor (32) and to said voltage sensor (34); said energy measurement unit (35) comprising a calculation module, which is configured for receiving said electrical measurement signals from said current sensor (32) and from said voltage sensor (34) and for calculating, on the basis of the latter, at least one value representative of the electrical energy associated with said electric current.

10. Measurement module (1) according to any one of the preceding claims, **characterized in that**:
- said measurement module (1) comprises at least two said electrical conductors (2);
- said at least one electrical sensor (3) comprises at least one differential current sensor (33) operatively associated with said at least two electrical conductors (2).

11. Measurement module (1) according to any one of the preceding claims, **characterized in that** it comprises a logic control unit (9), which is operatively connected at least to said electrical sensor (3) in order to receive from the latter at least said electrical measurement signal.

12. Measurement module (1) according to any one of the claims from 6 to 8 and claim 11, **characterized in that** said logic control unit (9) is operatively connected to said actuator (6), and is arranged for commanding the latter to switch said galvanic interruption device (5) between said open position and said closed position.

13. Measurement module (1) according to claim 1, 6 or 11, **characterized in that** it comprises a signal connector (96), which is operatively connected to at least one from among: said at least one electrical sensor (3), said actuator (6), said logic control unit (9), and is arranged for transmitting electrical signals from and towards said measurement module (1).

14. Electrical terminal board (7), which comprises:
- at least one first terminal (71), intended to be connected to at least one first electrical cable (73);
- at least one second terminal (72), intended to be connected to at least one second electrical cable (74);
- a measurement module (1) according to any one of the preceding claims, in which the input terminal (20) of said at least one electrical conductor (2) is electrically connected to said at least one first terminal (71), and the output terminal (21) of said at least one electrical conductor (2) is electrically connected to said at least one second terminal (72).

15. Recharge station (8) for an electric vehicle, which comprises:
- a containment body (80), which internally delimits a containment volume (V);
- at least one input line (82) intended to be connected to an energy source outside said containment volume (V);
- a measurement module (1) according to any one of the claims from 1 to 18, which is placed in said containment volume (V), with the input terminal (20) of said at least one electrical conductor (2) operatively connected to said at least one input line (82) and said output terminal (21) operatively connected to further components of said recharge station (8);
- an electrical connector (83) selected from among an electrical outlet and an electrical plug, and such electrical connector (83) is operatively connected to the output terminal (21) of said at least one electrical conductor (2) of said measurement module (1).
